# EUROPEAN PATENT SPECIFICATION

(11) **EP 2 544 319 B1**
(45) Date of publication and mention of the grant of the patent: **25.03.2015**
(21) Application number: 11290317.4
(22) Date of filing: 08.07.2011
(51) Int. Cl.: H01S 5/10, H01S 5/022

(54) **Laser source for photonic integrated devices**
Laserquelle für integrierte photonische Vorrichtungen
Source laser pour dispositifs photoniques intégrés

(43) Date of publication of application: 09.01.2013
(73) Proprietor: ALCATEL LUCENT, 92100 Boulogne-Billancourt (FR); Thales S.A., 92200 Neuilly sur Seine (FR); IMEC, 3001 Leuven (BE); Universiteit Gent, 9000 Gent (BE)
(72) Inventor: Lamponi, Marco, 92700 Colombes (FR); Poingt, Francis, 92700 Colombes (FR); Duan, Guang-Hua, 92700 Colombes (FR); De Valicourt, Guilhem, 92700 Colombes (FR); Keyvaninia, Shahram, 9000 Gent (BE); Roelkens, Günther, 9090 Melle (BE); Van Thourhout, Dries, 9050 Gent (BE)
(74) Representative: Lucas, Laurent Jacques

(56) References cited:
- WO-A2-02/058251
- LAMPONI M ET AL: "Heterogeneously integrated InP/SOI laser using double tapered single-mode waveguides through adhesive die to wafer bonding", GROUP IV PHOTONICS (GFP), 2010 7TH IEEE INTERNATIONAL CONFERENCE ON, IEEE, PISCATAWAY, NJ, USA, 1 September 2010 (2010-09-01), pages 22-24, XP031806974, ISBN: 978-1-4244-6344-2
- HYUNDAI PARK ET AL: "Device and Integration Technology for Silicon Photonic Transmitters", IEEE JOURNAL OF SELECTED TOPICS IN QUANTUM ELECTRONICS, IEEE SERVICE CENTER, PISCATAWAY, NJ, US, vol. 17, no. 3, 1 May 2011 (2011-05-01), pages 671-688, XP011326478, ISSN: 1077-260X, DOI: 10.1109/JSTQE.2011.2106112
- SYSAK M N ET AL: "A hybrid silicon sampled grating DBR tunable laser", GROUP IV PHOTONICS, 2008 5TH IEEE INTERNATIONAL CONFERENCE ON, IEEE, PISCATAWAY, NJ, USA, 17 September 2008 (2008-09-17), pages 55-57, XP031344425, ISBN: 978-1-4244-1769-8

## Description

The present invention relates to a laser source, and more especially a laser source for photonic integrated devices. The invention also relates to a method of manufacturing a laser source.

Laser sources and amplifiers are key elements of photonic integrated devices. This is particularly true for PICs (Photonic Integrated Circuits) on silicon, due to the lack of efficient silicon based light sources up to now. Hybrid integration of III-V material bonded to a Silicon On Insulator (SOI) wafer is nowadays considered as an efficient way to realize active devices for silicon PICs. In that kind of devices the light amplification takes place inside the III-V material. One of the critical problems is to design a laser structure, able to generate efficiently light in III-V materials and then to couple efficiently light from III-V material to silicon on insulator (SOI) material.

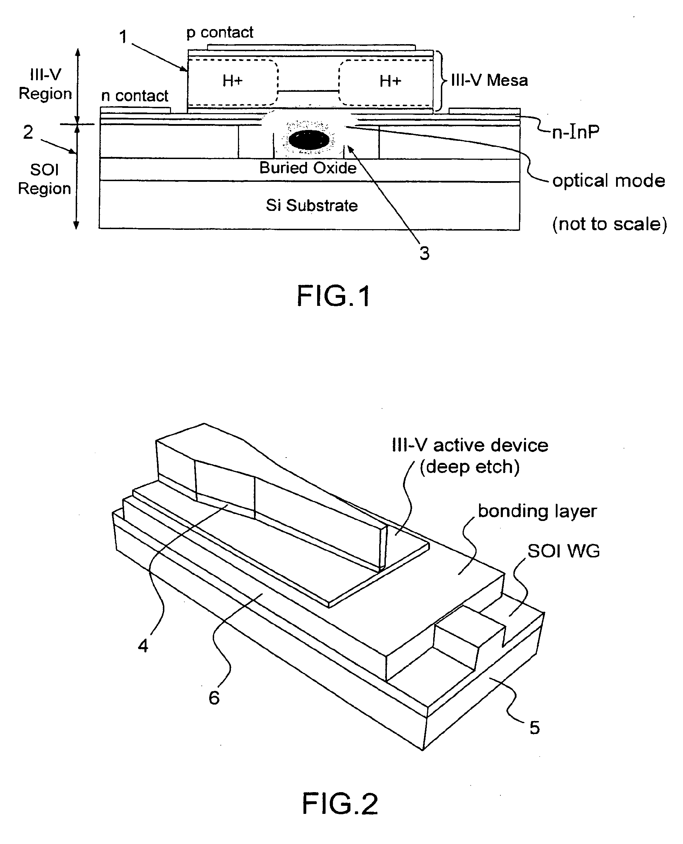

There exist at present two different solutions for solving these problems. The first solution, shown in Fig. 1, is to have closely stacked waveguide layers, with III-V material (1) on the top and SOI (2) on the bottom. As the distance between the III-V active layer and the silicon guiding layer is around 100 nm, the optical mode (3) guided by the silicon spreads over the III-V layers. The lateral mode guiding is achieved through the etching of the underlying silicon waveguide. The III-V waveguide has a much larger width than the passive one, its main function is to provide light amplification. At both ends of the active waveguide an adiabatic taper is used to minimize light reflection due to refractive index mismatch between the pure SOI waveguide and the combined SOI - III-V waveguide. It is to be noted that there is no bonding layer or a very thin bonding layer (< 30 nm) between silicon and III-V materials. The optical mode is strongly confined in the silicon waveguide and there is just an evanescent coupling with the multiple quantum wells layers. This solution is really sensitive to bonding quality because the optical mode always experiences the interface between III-V material and silicon, any small defects in the bonding between III-V material and SOI wafers will lead to device performance degradation or more seriously to unreliable devices. Moreover, the very thin n-doped

III-V layer results usually in quite a large electrical resistance, which leads to poor thermal behaviour under electrical injection.

According to the second solution (Fig. 2), the distance between the III-V active layer (4) and the silicon waveguide (5) is larger (300 nm typically) than in the first solution. Moreover there is a bonding layer (6) of a thickness of at least 50nm (in general a BCB or silica layer). The bonding layer has a low refractive index compared to that of the silicon and III-V materials. As a consequence, there is a very small mode overlapping overlapping between the mode guided in the 111-V waveguide and that in the SOI waveguide for the usual waveguide widths (2 to 4 µm for III-V waveguides and 0.5 11m for silicon waveguides). Mode coupling occurs only for tapered waveguides at the ends of the III-V waveguide. As the optical mode is completely transferred from one guide to the other in a limited tapered region, this structure is less sensitive to bonding defects. However, the mode transfer is only efficient for a deeply etched III-V waveguide. Deep ridge III-V waveguide means that the waveguide is formed by etching through the active layer down to the n-doped layer. Deep ridge III-V waveguides are known to be less robust and reliable compared to shallow ridge or buried ridge devices. In a shallow ridge structure the ridge is etched only above the active layer. Moreover, deep ridge waveguides suffer from high optical losses related to the light scattering by the roughness of the etched sidewalls. Surface recombination also occurs near the etched sidewalls, leading to high threshold current and low power efficiency. To our knowledge there are no deep ridge lasers commercially available up to now.

The article of Lamponi M. et al. in 2010 7TH IEEE International Conference on Group IV Photonics (GFP 2010), PISCATAWAY, NJ, USA, and titled "Heterogeneously integrated InP/SOI laser using double tapered single-mode waveguides through adhesive die to wafer bonding", and patent application WO02/058251 A2 from The Trustees of Princeton University, describe two possibilities to couple a III-V laser device to a lower waveguide.

An object of the present invention is a laser source and an amplifier of the III-V type bonded onto SOI type material, a laser source that is substantially not sensitive to the bonding quality, that has good thermal behaviour and that does not require deep etching of the most part of the III-V waveguide.

Another object of the invention is an opto-electronic component based on the advantageous technology of the invention's laser source, this component being one of the following components: an optical amplifier, a modulator, or a photo-detector.

The laser source of present invention is a source of the type comprising a III-V material die bonded onto a SOI material wafer, a central waveguide being formed in the etched III-V die and coupled to two end waveguides formed in the SOI wafer, the III-V die comprising a contact layer, a p-doped layer, a multi-quantum well region and a n-doped layer, and is characterized in that it comprises a shallow ridge structure for the III-V region, and a deep ridge structure for the tapered region for efficient mode coupling between III-V and SOI waveguides, the shallow ridge structure being a structure wherein the ridge is etched only above the active layer, whereas the deep ridge structure being a structure wherein the waveguide is formed by etching through the active layer down to the n-doped layer.

According to a preferred embodiment of the invention, the end of each SOI waveguide directed towards the III-V waveguide is tapered and shrinking towards the latter. In the region between the SOI waveguides, the III-V waveguide consists of a straight shallow ridge section (ridge width between 2 and 4 µm), terminated at boths ends of the straight section by tapered ridge waveguides. The III-V waveguide is on top of the SOI waveguide in the regions where the SOI waveguides are tapered. In those regions the III-V ridge waveguide is tapered typically with a waveguide width ranging from 1µm to 0.4µm. The last part with a length from 10 to 30µm of the III-V taper can be made optically absorbant around the lasing wavelength in order to eliminate residual reflections of the uncoupled light. Absorption behaviour can be achieved both by ions implantation or eliminiating electrical contact on the last part of the taper section. The straight section is a shallow ridge waveguide, in which the etching stops just above the active layer. In order to allow electrical injection, a second etching is carried out at a distance of several hundred nanometers to a few µms from the shallow ridge sidewalls.

According to a variant of the invention, the III-V waveguide contains two sections, one single-mode laser section including a periodically varying waveguide width, and an electro-absorption modulator section with identical layer structure as in the laser part. Typically, the period is around 240 nm in order to achieve lasing at a wavelength around 1550 nm. The variation of the waveguide width is usually in the range of less than 300 nm.

The realization of the structure of the invention is also a critical issue. Two lithographical steps are needed, the first one is to define the etching of the III-V die contact layer in InGaAs and of the p-type InP layer of the III-V die also, the second one to define the etching of the multi-quantum wells layer. The InGaAs contact layer and p-type InP layer that are protected during the first etching step have to be protected also during the second one. As it is difficult to have a perfect alignment between the first and the second lithographical layers, it is necessary to use a particular process for the fabrication of such kind of devices. An object of the invention is to use a hard mask to protect the InGaAs and the p-type InP layers during the first etching step, which is stopped just above the multi-quantum wells layer. Afterwards the metal mask, partially etched during the first etching step, is not removed and a second mask is defined. The MQW layer etched region will be the one, which is not protected by the first mask, neither by the second one. Then, the etching is performed and is stopped on top of the n-type InP layer. This process allows the realization of the structure with a realistic misalignment tolerance between the two mask layers.

Another variant is the use of a silicon waveguide, with a thickness larger than 400 nm. The typical value is 500 nm. In this case, only shallow etched III-V waveguide will be sufficient to achieve good coupling between III-V and SOI waveguides. According to a preferred embodiment of the invention, the laser consists of a central straight shallow ridge (ridge width between 2 and 4 µm) III-V waveguide section. On both sides of this central section a tapered part (around 20µm length) links the central section to the coupling part. The coupling part comprises a straight shallow ridge section of a different width for the III-V waveguide (depending on the silicon thickness), and an underlying tapered SOI waveguide. In those regions the SOI waveguide is tapered typically with a waveguide width ranging from 0.1µm to 2µm. At the end of the III-V waveguide a short tapered or untapered section (from 10 to 30µm) can be used to absorb the light around the lasing wavelength in order to elimininate residual reflection of the uncoupled light.

The hybrid laser source described in the present invention consists of thus the active III-V waveguide, as described above, passive silicon waveguides and tapers allowing the coupling between III-V and silicon waveguides. It consists also of a cavity which can be formed by two reflectors etched on silicon waveguides. One reflector should be located on the left side of the III-V waveguide, and the other on the right side of the III-V waveguides. The laser cavity can also be more complex, including for example ring resonators or an arrayed waveguide grating (AWG).

According to a first embodiment of the invention, the cavity comprises two end Bragg gratings etched on a silicon waveguide. The Bragg gratings are located at both ends of an III-V waveguide.

According to a second embodiment of the invention, the integrated laser - modulator comprises two sections, one single-mode laser section including a grating etched on III-V waveguide, and an electro-absorption modulator section with identical layer structure as in the laser part.

According to another embodiment, the laser cavity is defined between a Bragg grating and another type of reflector which is either a ring resonator or a sampled grating.

According to another embodiment, the last part of the III-V waveguide is optically absorbent around the lasing wavelength to avoid residual reflection of the uncoupled light.

The present invention will be better understood on reading the detailed description of an embodiment, taken by way of non limiting example and illustrated by the appended drawing in which:
- Figure 1 is a cross-section of a first prior art laser (not to scale),
- Figure 2 is perspective view of a second prior art laser source
- Figure 3 is a schematic top view of the laser structure of the invention with three different cross-section views,
- Figure 4 is a schematic view of a taper section in accordance with the invention, together with cross-section views of calculated mode transfer diagrams (light beam distribution) at four different points of the taper length,
- Figure 5 is a schematic view of a hybrid laser with shallow III-V waveguide and two ring resonators in accordance with the invention, this figure being deformed in the taper region for clarity purposes, and,
- Figure 6 is a schematic view of a hybrid laser with an AWG, according to the invention.

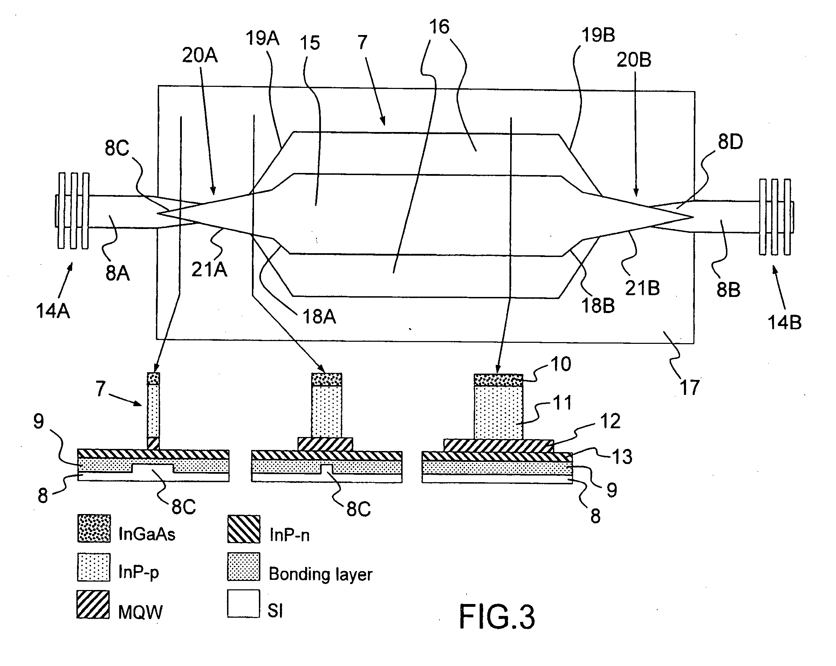

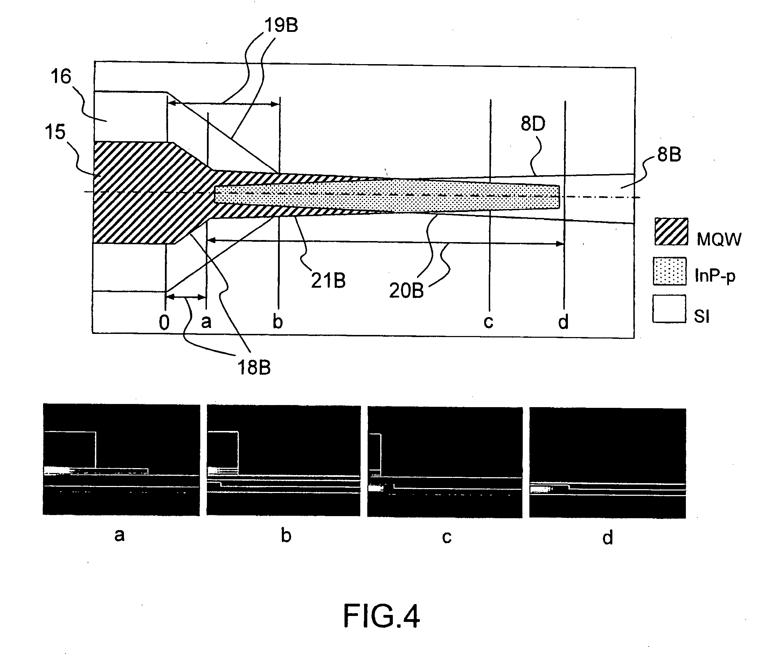

The basic feature of the invention is the use of a shallow ridge structure for the III-V straight waveguide region to provide efficient light amplification, and a deep ridge structure for the tapered region for efficient mode coupling from III-V to SOI waveguides. This solution dramatically improves the performances of the hybrid III-V lasers on silicon. It allows to reach the coupling efficiency of the deep ridge structure and the performance and reliability of the shallow ridge structure. The hybrid laser of the invention with such a shallow-deep ridge transition is shown in figures 3 and 4.

According to the invention (see Figure 3), an III-V die, in which is formed a segment of waveguide 7, is bonded on a SOI wafer 8 by means of a bonding layer 9 of a thickness of about 50nm for example. The III-V die has the following vertical structure (from the top to the bonding layer): a contact layer 10 (usually InGaAs), a thick InP p-doped layer 11 (thickness around 2µm), a multi-quantum well region 12 including both InGaAsP (or InGaAlAs) wells and barriers or other heterostructures, and a thin InP n-doped layer 13 (typical thickness: about 200nm).

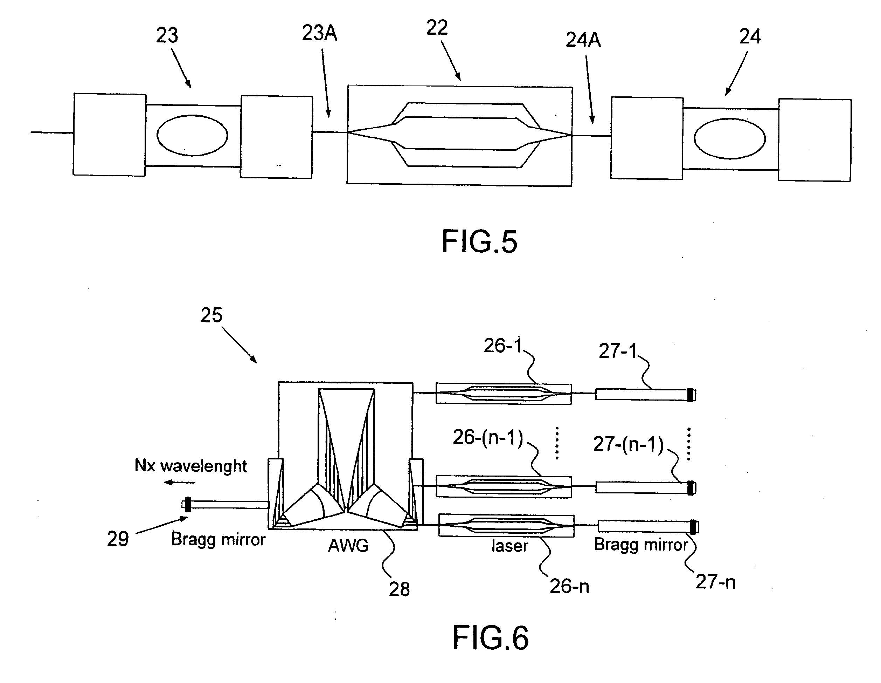

Fig. 3 shows a top view of the laser structure according to the invention. This structure comprises two end Bragg grating regions 14A, 14B etched on a silicon end segment of waveguide 8A, 8B respectively. These end waveguides are aligned and formed themselves in the SOI material. According to a variant (not shown), these gratings are sampled gratings in order to achieve wavelength tuning through the current injection into the doped silicon waveguides, or thermal tuning with heater. According to another variant (see figure 5), these gratings are replaced by ring resonators allowing also to achieve wavelength tuning.

According to another variant (see figure 6), these gratings are replaced by arrayed waveguide gratings formed in the silicon waveguides.

In between the two Bragg grating regions 14A, 14B, each of the end waveguides 8A, 8B is tapered (8C, 8D respectively) towards the center of the structure. The tapered ends 8C, 8D are coupled to the III-V waveguide 7 which comprises three parts (as seen in the top view of figure 3, in a transverse direction). The central part 15 represents the area without any etching of the III-V die. The first lateral part 16 is the area in which the etching is stopped just above the active region (12). Then the second lateral part 17, wider than the first one, is the area in which the etching is stopped just below the active region (12). In order to allow smooth mode transition from shallow ridge 7 to deep ridge 8A, 8B, two kinds of tapers are manufactured at each end of the III-V die: the first one allows the transition from shallow ridge to deep ridge, and the second one from deep ridge to silicon (SOI) waveguide.

According to the invention, the taper sections may have different structures, either linear or not, single or double or even more complex. For instance, for a 400nm silicon waveguide, it will be used a double taper structure to achieve the right index difference at the transition between shallow ridge and deep ridge and thus enable efficient coupling.

A non limitative example of a taper structure, that of the right side of the structure of figure 3, comprising three tapers (18B, 19B, 20B), is detailed in Fig. 4. An example of the corresponding mode transfer diagrams calculated with an appropriate software is shown in the bottom part of this figure 4 for four different locations along the length of the taper section (respectively at a, b, c and d locations that are shown in the upper diagram of figure 4). These mode transfer diagrams clearly show that the light beam transfer from one ridge to the other occurs very smoothly, i.e. it is an adiabatical transfer of the optical mode from shallow ridge III-V waveguide to deep ridge III-V waveguide). A first taper, of a typical length of 30µm, 18A, 18B, shrinking towards the corresponding Bragg grating 14A, 14B, is formed at each end of the central part 15 of waveguide 7. A second taper 19A, 19B, of a typical length of 100µm, linking the shallow etch part of the structure with the deep etch part, is formed at each end of the lateral part 16 of waveguide 7. A third dual taper 20A, 20B, of a typical length of 150µm, comprises a first part 21A, 21B that extends the first taper 18A, 18B, is also shrinking towards the corresponding Bragg grating and overlapping the second part of the dual taper, that is in fact the taper 8C, 8D of the corresponding silicon waveguide 8A, 8B. Typically the total length of a taper is between 100 and 150 µm for the operation wavelength of 1.5 µm.

Distinct functions are assigned to the tapers of this section: tapers 18A, 18B and 20A, 20B are designed to efficiently couple the light between silicon and III-V waveguides, whereas taper 19A, 19B is designed for reducing coupling losses and reflections due to the mode effective index mismatching between the shallow ridge waveguide and the deep ridge tapered waveguide.

More precisely, taper 18A, 18B reduces the optical mode size to a more suitable dimension for coupling. Taper 20A, 20B is composed of two overlapping tapers, one (8C, 8D) made in the silicon waveguide and one made in the III-V waveguide (21A, 21B). The taper 19A, 19B allows transferring adiabatically the optical mode from shallow ridge III-V waveguide to deep ridge III-V waveguide.

The laser sources in silicon based photonic integrated circuits most likely will be based on the heterogeneous integration of InP on silicon. As this invention proposes a novel laser source structure which is more stable, robust and efficient than the existing ones, it could become a standard for the production of hybrid silicon III-V lasers in these photonic integrated circuits.

Compared to the solution in which the optical mode spreads between SOI and III-V guiding layers, the solution of the invention is less sensitive to bonding defects, leading to higher yield and higher reliability. Moreover, the power efficiency should also be better due to better lateral carrier confinement.

Compared to the solution using deep ridge waveguide InP structure, the use of a shallow ridge leads to higher laser performance (better power efficiency, low threshold current) and higher reliability.

Fig. 5 schematically shows a hybrid laser with shallow III-V waveguide 22. The laser incorporates two ring resonators 23, 24 with different free spectral range. Each ring resonator, together with multimode interface (MMI) couplers 23A, 24A respectively, provides a comb of reflection peaks. The lasing occurs when one peak of one comb coincides with another peak of another comb. Such a configuration allows thus to make tunable lasers by shifting one reflection comb through thermal or electrical effects.

Fig. 6 shows a hybrid laser with an AWG. (Arrayed Waveguide Grating), here used as an optical multiplexer. This laser 25 comprises: a series of solid state structures 26-1,...26-(n-1),26-n similar to that shown in figure 3, each of them operates at a different wavelength. One end of each of these structures is connected to a Bragg mirror structure, respectively referenced 27-1,...27-(n-1),27-n. The other end of each of these structures is connected to a corresponding input of an AWG referenced 28. The output of the AWG 28 is connected to a Bragg mirror structure 29.

The hybrid laser 25 allows it to make a multi-wavelength laser or wavelength selectable laser by selecting an input of the AWG 28, thus selecting the corresponding laser among 26-1 to 26-n.

## Claims

1. Laser source of the type comprising a III-V material die bonded onto a silicon on insulator, named SOI hereinafter, material wafer (8), a central waveguide (7) being formed in the III-V material die and coupled to two end waveguides (8A, 8B) formed in the SOI material wafer, the III-V material die comprising a contact layer (10), a p-doped layer (11), a multi-quantum well active region (12), and a n-doped layer (13), the laser source further comprising a shallow ridge structure in an etched region of the III-V material die and a deep ridge structure in a tapered region of the III-V material die for efficient mode coupling between the central waveguide formed in the III-V material die and the end waveguides (8A, 8B) formed in the SOI material wafer, the shallow ridge structure being a structure wherein the ridge is etched only above an active layer of the III-V material die, whereas the deep ridge structure being a structure wherein the central waveguide is formed by etching through the active layer down to the n-doped layer, and wherein each end waveguide (8A, 8B) formed in the SOI material wafer directed towards the central waveguide (7) is tapered (8C, 8D) and shrinking towards the latter so that a tapered region is formed, and wherein each tapered end waveguide between the central waveguide and the end waveguides formed in the SOI material wafer comprises a first taper (18A, 18B) formed at each end of a central part (15) of the central waveguide that represents the area without any etching of the III-V material die, a second taper (19A, 19B) formed at each end of a lateral part of the central waveguide, this lateral part (16) being the area in which the etching of the III-V material die is stopped above the active region (12) of the III-V material die, and a third taper (20A, 20B) comprising a first part (21A, 21B) that extends the corresponding first taper (18A, 18B) and that is overlapping a second part (8C, 8D) belonging to the tapered region of the corresponding end waveguide (8A, 8B) formed in the SOI material wafer.

2. Laser source according to claim 1 **characterized in that** the III-V material die has the following vertical structure, from top to down : a contact layer (10), an InP p-doped layer (11), a multi-quantum well region (12), and a thin InP n-doped layer (13).

3. Laser source according to claim 2, **characterized in that** the InP p-doped layer (11) has a thickness of around 2µm, that the multi-quantum well region (12) includes both wells and barriers, and that the InP n-doped layer (13) has a thickness of about 200nm.

4. Laser source according to claim 3, **characterized in that** the material of wells is InGaAsP or InGaA1As or selected from other III-V alloys providing optical gain.

5. Laser source according to any of claims 1 to 4, **characterized in that** it comprises two wavelength selective reflectors formed on the two ends waveguides formed in the SOI material wafer and defining between themselves a laser cavity.

6. Laser source according to 5, **characterized in that** the reflectors are Bragg gratings (14A-14B) etched in the two ends waveguides formed in the SOI material wafer and located at both ends of the central waveguide.

7. Laser source according to claim 5, **characterized in that** the reflectors are sampled gratings etched in the two ends waveguides formed in the SOI material wafer in order to achieve wavelength tuning.

8. Laser source according to claim 5, **characterized in that** the reflectors are ring resonators in the two ends waveguides formed in the SOI material wafer.

9. Laser source according to claim 5, **characterized in that** the laser cavity comprises an arrayed waveguide grating (28).

10. Laser source according to claim 5, **characterized in that** the laser cavity is defined between a Bragg grating and another type of reflector which is either a ring resonator or a sampled grating.

11. Laser source according to any of preceding claims, **characterized in that** it is an integrated laser-modulator and **in that** the central waveguide contains two sections, one single-mode laser section including a grating etched on central waveguide, and an electro-absorption modulator section with identical layer structure as in the laser part.

12. Laser source according to any preceding claim, **characterized in that** a last part of the central waveguide (21A, 21B) is optically absorbent around the lasing wavelength to avoid residual reflection of the uncoupled light.

13. Opto-electronic component comprising the laser source according to any of claims 5 to 12, **characterized in that** a laser cavity is defined by reflectors that are formed outside the central and SOI waveguide parts.

14. Opto-electronic component according to claim 13, **characterized in that** it is one of the following components: an optical amplifier, a modulator, or a photo-detector.

## Patentansprüche

1. Laserquelle des Typs, der Folgendes umfasst: einen Chip aus III-V-Material, der auf einen Wafer (8) aus Silizium-auf-Isolator-Material, hierin nachstehend SOI genannt, gebondet ist, einen zentralen Wellenleiter (7), der in dem Chip aus III-V-Material ausgebildet und mit zwei in dem SOI-Materialwafer ausgebildeten Endwellenleitern (8A, 8B) gekoppelt ist, wobei der Chip aus III-V-Material eine Kontaktschicht (10), eine p-dotierte Schicht (11), eine aktive Mehrfach-Quantentopfregion (12) und eine n-dotierte Schicht (13) umfasst, wobei die Laserquelle ferner zur effizienten Modenkopplung zwischen dem im Chip aus III-V-Material ausgebildeten zentralen Wellenleiter und den im SOI-Materialwafer ausgebildeten Endwellenleitern (8A, 8B) eine flache Kantenstruktur in einer geätzten Region des Chips aus III-V-Material und eine tiefe Kantenstruktur in einer verjüngten Region des Chips aus III-V-Material umfasst, wobei die flache Kantenstruktur eine Struktur ist, worin die Kante nur über einer aktiven Schicht des Chips aus III-V-Material geätzt ist, während die tiefe Kantenstruktur eine Struktur ist, worin der zentrale Wellenleiter durch Ätzen durch die aktive Schicht hinunter zur n-dotierten Schicht ausgebildet ist, und worin jeder im SOI-Materialwafer ausgebildete zum zentralen Wellenleiter (7) gerichtete Endwellenleiter (8A, 8B) verjüngt ist (8C, 8D) und zu letzterem hin schrumpft, sodass die verjüngte Region ausgebildet wird, und worin jeder verjüngte Endwellenleiter zwischen dem zentralen Wellenleiter und den im SOI-Materialwafer ausgebildeten Endwellenleitern umfasst: eine erste Verjüngung (18A, 18B), die an jedem Ende eines zentralen Teils (15) des zentralen Wellenleiters ausgebildet ist, der die Region ohne jede Ätzung des Chips aus III-V-Material darstellt, eine zweite Verjüngung (19A, 19B), die an jedem Ende eines seitlichen Teils des zentralen Wellenleiters ausgebildet ist, wobei dieser seitliche Teil (16) derjenige Bereich ist, in dem die Ätzung des Chips aus III-V-Material über der aktiven Region (12) des Chips aus III-V-Material angehalten wird, und eine dritte Verjüngung (20A, 20B), die einen ersten Teil (21A, 21B) umfasst, der die entsprechende erste Verjüngung (18A, 18B) verlängert und der einen zweiten Teil (8C, 8D) überlappt, der zu der verjüngten Region der entsprechenden im SOI-Materialwafer ausgebildeten Endwellenleiter (8A, 8B) gehört.

2. Laserquelle nach Anspruch 1, **dadurch gekennzeichnet, dass** der Chip aus III-V-Material die folgende vertikale Struktur hat, von oben nach unten: eine Kontaktschicht (10), eine p-dotierte InP-Schicht (11), eine Mehrfach-Quantentopfregion (12) und eine dünne n-dotierte InP-Schicht (13).

3. Laserquelle nach Anspruch 2, **dadurch gekennzeichnet, dass** die p-dotierte InP-Schicht (11) eine Dicke von rund 2 µm hat, dass die Mehrfach-Quantentopfregion (12) sowohl Töpfe als auch Barrieren aufweist und dass die n-dotierte InP-Schicht (13) eine Dicke von rund 200 nm hat.

4. Laserquelle nach Anspruch 3, **dadurch gekennzeichnet, dass** das Material der Töpfe InGaAsP oder InGaAlAs ist oder aus anderen III-V-Legierungen ausgewählt wird, die optische Verstärkung bieten.

5. Laserquelle nach einem der Ansprüche 1 bis 4, **dadurch gekennzeichnet, dass** sie zwei wellenlängenselektive Reflektoren umfasst, die auf den beiden im SOI-Materialwafer ausgebildeten Endwellenleitern ausgebildet sind und zwischen sich einen Laserresonator definieren.

6. Laserquelle nach Anspruch 5, **dadurch gekennzeichnet, dass** die Reflektoren Bragg-Gitter (14A-14B) sind, die in die beiden im SOI-Materialwafer ausgebildeten Endwellenleiter geätzt und an beiden Enden des zentralen Wellenleiters angeordnet sind.

7. Laserquelle nach Anspruch 5, **dadurch gekennzeichnet, dass** die Reflektoren Sampled-Grating-Gitter sind, die in die beiden im SOI-Materialwafer ausgebildeten Endwellenleiter geätzt sind, um eine Wellenlängenabstimmung zu erzielen.

8. Laserquelle nach Anspruch 5, **dadurch gekennzeichnet, dass** die Reflektoren Ringresonatoren in den beiden im SOI-Materialwafer ausgebildeten Endwellenleitern sind.

9. Laserquelle nach Anspruch 5, **dadurch gekennzeichnet, dass** der Laserresonator ein Arrayed-Waveguide-Gitter (28) umfasst.

10. Laserquelle nach Anspruch 5, **dadurch gekennzeichnet, dass** der Laserresonator zwischen einem Bragg-Gitter und einem anderen Reflektortyp definiert ist, der entweder ein Ringresonator oder ein Sampled-Grating-Gitter ist.

11. Laserquelle nach einem der vorhergehenden Ansprüche, **dadurch gekennzeichnet, dass** sie ein integrierter Laser und Modulator ist und dass der zentrale Wellenleiter zwei Abschnitte enthält: einen Einzelmodelaserabschnitt, der ein auf den zentralen Wellenleiter geätztes Gitter aufweist, und einen Elektroabsorptionsmodulatorabschnitt mit identischer Schichtstruktur wie im Laserteil.

12. Laserquelle nach einem der vorhergehenden Ansprüche, **dadurch gekennzeichnet, dass** zumindest ein Teil des zentralen Wellenleiters (21A, 21B) um die Laserwellenlänge herum optisch absorbiert, um Restreflexion des ungekoppelten Lichts zu vermeiden.

13. Optoelektronisches Bauelement, das die Laserquelle nach einem der Ansprüche 5 bis 12 umfasst, **dadurch gekennzeichnet, dass** ein Laserresonator durch Reflektoren definiert ist, die außerhalb der zentralen und SOI-Wellenleiterteile ausgebildet sind.

14. Optoelektronisches Bauelement nach Anspruch 13, **dadurch gekennzeichnet, dass** es eines der folgenden Bauelemente ist: ein optischer Verstärker, ein Modulator oder ein Fotodetektor.

## Revendications

1. Source laser du type comprenant une puce en matériau de type III-V fixée sur une tranche (8) d'un matériau silicium sur isolant, appelé ci-dessous SOI, un guide d'ondes central (7) étant formé dans la puce en matériau III-V et couplé à deux guides d'ondes d'extrémité (8A, 8B) formés dans la tranche de matériau SOI, la puce en matériau III-V comprenant une couche de contact (10), une couche à dopage p (11), une région active à puits quantiques multiples (12), et une couche à dopage n (13), la source laser comprenant en outre une structure à nervure peu profonde dans une région gravée de la puce en matériau III-V et une structure à nervure profonde dans une région effilée de la puce en matériau III-V pour un couplage de mode efficace entre le guide d'ondes central formé dans la puce en matériau III-V et les guides d'ondes d'extrémité (8A, 8B) formés dans la tranche de matériau SOI, la structure à nervure peu profonde étant une structure dans laquelle la nervure est gravée seulement au-dessus d'une couche active de la puce en matériau III-V, tandis que la structure à nervure profonde est une structure dans laquelle le guide d'ondes central est formé par gravure à travers la couche active jusqu'à la couche à dopage n, et dans laquelle chaque guide d'ondes d'extrémité (8A, 8B) formé dans la tranche de matériau SOI et dirigé vers le guide d'ondes central (7) est effilé (8C, 8D) et se rétrécit en direction de ce dernier de sorte qu'une région effilée est formée, et dans laquelle chaque guide d'ondes d'extrémité effilé entre le guide d'ondes central et les guides d'ondes d'extrémité formés dans la tranche de matériau SOI comprend un premier cône (18A, 18B) formé au niveau de chaque extrémité d'une partie centrale (15) du guide d'ondes central qui représente la zone sans aucune gravure de la puce en matériau III-V, un deuxième cône (19A, 19B) formé au niveau de chaque extrémité d'une partie latérale du guide d'ondes central, ladite partie latérale (16) étant la zone dans laquelle la gravure de la puce en matériau III-V est interrompue au-dessus de la région active (12) de la puce en matériau III-V, et un troisième cône (20A, 20B) comprenant une première partie (21A, 21B) qui prolonge le premier cône (18A, 18B) correspondant et qui chevauche une seconde partie (8C, 8D) appartenant à la région effilée du guide d'ondes d'extrémité (8A, 8B) correspondant formé dans la tranche de matériau SOI.

2. Source laser selon la revendication 1, **caractérisée en ce que** la puce en matériau III-V présente la structure verticale suivante, de haut en bas : une couche de contact (10), une couche de phosphure d'indium InP à dopage p (11), une région à puits quantiques multiples (12), et une couche fine de InP à dopage n (13).

3. Source laser selon la revendication 2, **caractérisée en ce que** la couche de InP à dopage p (11) présente une épaisseur d'environ 2 µm, la région à puits quantiques multiples (12) comprend à la fois des puits et des barrières, et la couche de InP à dopage n (13) présente une épaisseur d'environ 200 nm.

4. Source laser selon la revendication 3, **caractérisée en ce que** le matériau des puits est du InGaAsP ou du InGaAlAs ou est sélectionné parmi d'autres alliages de type III-V fournissant un gain optique.

5. Source laser selon l'une quelconque des revendications 1 à 4, **caractérisée en ce qu'**elle comprend deux réflecteurs à sélection de longueur d'onde formés sur les deux guides d'ondes d'extrémité formés dans la tranche de matériau SOI et définissant entre eux une cavité laser.

6. Source laser selon la revendication 5, **caractérisée en ce que** les réflecteurs sont des réseaux de Bragg (14A-14B) gravés dans les deux guides d'ondes d'extrémité formés dans la tranche de matériau SOI et situés aux deux extrémités du guide d'onde central.

7. Source laser selon la revendication 5, **caractérisée en ce que** les réflecteurs sont des réseaux échantillonnés gravés dans les deux guides d'ondes d'extrémité formés dans la tranche de matériau SOI afin de parvenir à un réglage de longueur d'onde.

8. Source laser selon la revendication 5, **caractérisée en ce que** les réflecteurs sont des résonateurs en anneau dans les deux guides d'ondes d'extrémité formés dans la tranche de matériau SOI.

9. Source laser selon la revendication 5, **caractérisée en ce que** la cavité laser comprend un réseau formant guide d'onde disposé en grille (28).

10. Source laser selon la revendication 5, **caractérisée en ce que** la cavité laser est définie entre un réseau de Bragg et un autre type de réflecteur qui est un résonateur en anneau ou un réseau échantillonné.

11. Source laser selon l'une quelconque des revendications précédentes, **caractérisée en ce qu'**elle est un modulateur laser intégré et le guide d'ondes central contient deux sections, une section à laser monomode comprenant un réseau gravé sur le guide d'ondes central, et une section à modulateur électro-absorbant avec une structure de couche identique à celle de la partie laser.

12. Source laser selon l'une quelconque des revendications précédentes, **caractérisée en ce qu'**une dernière partie du guide d'ondes central (21A, 21B) est optiquement absorbante autour de la longueur d'onde de lasage afin d'éviter une réflexion résiduelle de la lumière non couplée.

13. Composant optoélectronique comprenant la source laser selon l'une quelconque des revendications 5 à 12, **caractérisé en ce qu'**une cavité laser est définie grâce à des réflecteurs qui sont formés à l'extérieur des parties guide d'ondes central et guide d'ondes SOI.

14. Composant optoélectronique selon la revendication 13, **caractérisé en ce qu'**il s'agit d'un composant parmi les composants suivants : un amplificateur optique, un modulateur, ou un photodétecteur.
